# EUROPEAN PATENT SPECIFICATION

(11) **EP 2 555 850 B1**
(45) Date of publication and mention of the grant of the patent: **26.07.2017**
(21) Application number: 11713265.4
(22) Date of filing: 07.04.2011
(51) Int. Cl.: C23C 16/44, H01L 21/306, B01D 53/68

(54) **METHOD FOR THE MANUFACTURE OF ELECTRONIC DEVICES WITH PURIFIED FLUORINE**
VERFAHREN ZUR HERSTELLUNG VON ELEKTRONISCHEN VORRICHTUNGEN MIT GEREINIGTEM FLUOR
PROCÉDÉ DE FABRICATION DE DISPOSITIFS ÉLECTRONIQUES AVEC DU FLUOR ÉPURÉ

(30) Priority: 08.04.2010 EP 10159285
(43) Date of publication of application: 13.02.2013
(73) Proprietor: SOLVAY SA, 1120 Bruxelles (BE)
(72) Inventor: SOMMER, Christoph, 74172 Neckarsulm (DE); DIANA, Oliviero, B-1800 Vilvoorde (BE); EICHER, Johannes, 31319 Sehnde (DE); UENVEREN, Ercan, 30625 Hannover (DE); MROSS, Stefan, B-1030 Brussels (BE); PERNICE, Holger, 28790 Schwanewede (DE); PREDIKANT, Peter, M., 30519 Hannover (DE); SCHWARZE, Thomas, 31275 Ahlten (DE); FISCHER, Reiner, 38173 Dettum (DE)
(74) Representative: Mross, Stefan P.M.
(86) International application number: PCT/EP2011/055425
(87) International publication number: WO 2011/124642

(56) References cited:
- EP-A1- 0 506 588
- WO-A1-2006/043125
- US-A1- 2002 074 013

## Description

The invention concerns a method for the manufacture of electronic devices with purified elemental fluorine.

Elemental fluorine (F₂) is often produced electrolytically from hydrogen fluoride (HF) in the presence of an electrolyte salt, usually in the presence of a molten HF adduct of KF having a formula of about KF· (1.8 to 2.3)HF at a voltage of at least 2.9 V (in practice, between 8 and 10 or 11 V) according to the equation (1) :

2HF → H₂ + F₂ (1)

F₂ is useful as etchant for the manufacture of electronic devices, especially semiconductors, photovoltaic cells, micro-electromechanical systems ("MEMS"), TFTs (thin film transistors for flat panel displays or liquid crystal displays), and the like, and as cleaning agent for treatment chambers used in the manufacture of electronic devices. For the manufacture of semiconductors, photovoltaic cells, MEMS and TFTs, several consecutive steps of deposition of layers and etching a part of them are performed in treatment chambers ; fluorine can be used for etching of layers constituted of very different constitution, for example, for etching silicon containing layers. Usually, during deposition processes performed in the treatment chambers - often CVD chambers (chambers wherein layers are deposited on items via chemical vapor deposition, e.g. plasma-enhanced CVD, metal organic CVD or low pressure CVD) - undesired deposits form on the walls and on inner constructive parts of the chamber and must be regularly removed. This is achieved by treating the deposits thermally or plasma-enhanced with elemental fluorine as chamber cleaning agent.

Fluorine is a very reactive molecule, and thus, for plants with a respectively great demand, elemental fluorine is preferably produced on-site. This means, that one or more fluorine generators are located on the site of the tools, and preferably, in proximity of the tools (CVD chambers, etching chambers) for manufacturing the electronic devices. It is especially preferred that the fluorine generator or generators be in fluid contact with one or more of the tools such that it is not necessary to fill the fluorine into a storage tank or into pressure bottles and transport it on or to the site of use.

Especially for the use of elemental fluorine as an etchant, but also when used as chamber cleaning agent, it is desirable that the elemental fluorine be very pure. Entrained solids and hydrogen fluoride (HF) are considered as especially undesired impurities.

WO 2006/043125 discloses a fluorine gas generator disposed in the gas feed system of a semiconductor plant. The pressure in the electrolytic cells is set to ambient pressure up to 820 torr and preferably, to ambient pressure up to 770 torr, and the pressure in a buffer tank is set, for example, to 0.18 MPa above atmospheric pressure (i.e. to about 2.8 Bara)

At that point it is mentioned that one Torr equals 133 Pascals.

In the description of the invention the pressures are all absolute pressures. It will be referred to bar absolute, or alternatively to Bara, bar absolute or bar (abs), all these expressions being considered equivalent.

US patent 5,589,148 discloses a method for purifying fluorine wherein impure fluorine is contacted with an alkaline earth metal hydroxide and an iron oxide.

US patent 2,960,835 and WO 02/50334 (corresponding to US patent application publication 2002/0074013) disclose the removal of HF from F₂ by a low temperature treatment.

Object of the present invention is to provide an improved process for delivery of purified fluorine as agent to a process for the manufacture of electronic devices wherein it is desirable to use pure reagents.

The invention concerns a method for the manufacture of electronic devices comprising at least a step of the manufacture of the elemental fluorine on site electrolytically and cleaning a chamber using elemental fluorine as chamber cleaning agent wherein, after its manufacture, the elemental fluorine and before its application for chamber cleaning is subjected to a low temperature treatment, wherein the elemental fluorine is cooled to a temperature equal to or lower than -60°C, at a pressure of equal to or greater than 1.5 Bar Absolute to remove at least a part of entrained hydrogen fluoride and subsequently subjected to at least one absorption step.

The term "low temperature treatment" denotes a contact of the fluorine to be purified with cooled surfaces of a cooling apparatus, e.g. a cooled trap or a cooled heat exchanger wherein the cooled surfaces are cooled to a temperature of equal to or lower than -60°C. The temperature is preferably equal to or higher than -185°C because, at ambient pressure, the boiling point of fluorine is about -188°C. Cooling liquids for this temperature range are generally known, e.g. from R. E. Rondeau, J. Chem. Eng. Data, II, 124 (1966). US patent application publication 2009-0026410 provides heat transfer fluids comprising an ether and an alkylbenzene which are suitable in heat exchangers operating at temperatures as low as -115°C. The melting point of HF under standard pressure (100 kPa) is -83.6°C. Thus, under the conditions of the process of the invention, and depending from the pressure, the HF in the trap will solidify if the temperature is respectively low ; the higher the pressure, the lower the temperature at which the HF solidifies.

The pressure of the fluorine during the low temperature treatment is equal to or greater than 1.5 Bar absolute (150 kPa abs.) ; the term "Bar abs." is equivalent to "Bara". More preferably, the pressure is equal to or greater than 2 bar (abs). The pressure is preferably equal to or lower than 20 Bara (2.000 kPa abs.), and more preferably, it is equal to or lower than 15 Bara (1.500 kPa abs).

Performing the process at a pressure in the upper region, e.g. between 6 and 20 bar (abs.), at a given temperature improves the separation of the entrained HF because the partial pressure of HF is lower at a higher pressure, and thus the residual content of HF in the treated fluorine is lower. On the other hand, for practical reasons it may be preferred to perform the process at a lower pressure, e.g. in the range from 2 to 4 bar (abs.) because F₂ is a very aggressive compound.

While performing the process at a temperature as low as possible improves the separation factor (because the partial pressure of HF is lower), it is preferred to select pressure and temperature such that the separated HF does not solidify because the separated HF can be removed from the trap more easily in liquid state than HF being in a solid state. The removal of HF at conditions at which the condensed HF is liquid is preferred. As mentioned above, at ambient pressure, HF solidifies at about -83.6°C. Under the elevated pressure of the process of the invention, the solidification temperature is lower, thus, the process can be performed at temperatures even lower than -83.6°C. A preferred range for the treatment at low temperature is from equal to or greater than -70°C to equal or higher than -82°C.

The fluorine is manufactured on site. It can be produced in one or more satellite plants, e.g. in a fluorine generating cassette as described in WO 2004/009873. If desired, each cassette can be allocated to one or more process chambers wherein etching is performed ; or a plurality of fluorine generating cassettes is connected to a fluorine gas distribution system which is connected to the chambers. The means, for performing the inventive method for the low temperature purification can be integrated into the cassette.

The process can also be performed in the frame of a plant according to the skid concept as described in unpublished US provisional patent applications no. 61/383204, filed Sep. 15, 2010, and 61/383533, filed Sep. 16, 2010, both filed in the name of Solvay SA.

The pressure of delivery of the fluorine to the tool is preferably equal to or greater than 3 Bara (300 kPa abs.), and especially preferably, equal to or greater than 4.5 Bara (450 kPa abs). In this embodiment, the pressure is preferably equal to or lower than 12 Bara (1.200 kPa abs), and more preferably, it is equal to or lower than 11 Bara (1.100 kPa abs). An especially preferred range in this embodiment is 4.5 to 11 Bara (450 to 1.100 kPa abs). In this embodiment, the process of the present invention and the delivery to the tool are preferably performed at a pressure in the range of 8 to 12 Bara (800 to 1200 hPa). The advantage is that no additional pressurization is needed. If the process of the invention is performed at a lower pressure than the step of the fluorine delivery to the tool, the fluorine must be pressurized in a compressor or other means. The manufacture of TFTs and etching agents comprising F₂ useful therein is described in unpublished EP patent application 09174034.0 filed on 26 Oct 2009 (corresponding to unpublished international patent application no. PCT/EP2010/066109 filed on Oct. 26, 2010).

By means of the low temperature treatment, HF which usually is entrained in electrolytically produced F₂ can be removed effectively. A further treatment with an adsorbent, e.g. NaF, is performed after the low temperature treatment. The fluorine can be contacted with the adsorbent under the same pressure as applied for removing HF from it at low temperature. Alternatively, the fluorine can be pressurized to a higher pressure or depressurized to a lower pressure for contacting it with the absorbent. Additionally, a step of pressure distillation can be performed. Entrained solids which are mainly composed of solidified electrolyte salt can be removed in a frit made from F₂-resistant material, especially stainless steel, nickel or Monel metal.

According to one embodiment, the removal of solids from the electrolytically produced F₂ can be performed by passing the F₂ through a jet scrubber operated with liquid HF at a low temperature, e.g. with liquid HF at a temperature of -70°C or lower, down to -82°C. Such a treatment is described in European patent application no. 10172034.0 filed Aug 05, 2010 in the name of Solvay SA.

In a combination of low temperature treatment and adsorption, the advantage is that less absorbent must be regenerated. The removed HF can be recycled to the electrolysis reactor.

The "chamber" is a chamber wherein electronic devices are etched thermally or assisted by a remote and/or internal plasma, or it is a chamber used for deposition of layers, e.g. by chemical vapor deposition (CVD), especially a plasma-enhanced CVD chamber (PECVD) which is to be cleaned from time to time or according to a schedule to remove undesired deposits which accumulate on the walls and internal parts.

The steps of purification can be performed before or after storage or buffering (if a step of storage or buffering is foreseen). If desired, the fluorine can be purified before and after storage.

After its manufacture and purification, the fluorine is delivered to the point of use. This is preferably performed under a pressure which is greater than ambient pressure.

In a preferred embodiment, the fluorine is pressurized by means of compressors. If acceptable for the intended purpose, pressurizing inert gases can be applied, for example, nitrogen, oxygen, helium or argon. Preferably, no pressurizing gas is applied, except for elemental fluorine as pressurizing gas.

The step of storage, if foreseen, preferably denotes the storage of the elemental fluorine in suitable tanks, e.g. stainless steel bottles.

The fluorine is preferably generated on site of its point of use via electrolysis in an apparatus which is in fluid communication with the process chamber or process chambers. This means that the generated elemental fluorine is not filled into a storage tank or into pressurized bottles, which are then disconnected from the delivery line. If desired, the fluorine is stored in storage tanks, buffer tanks or bottles only which remain connected to the delivery line. Often, the fluorine generator is located on the same plant as the tools wherein it is used, i.e. in a distance of less than 500 m from the manufacturing tools ; the generator often will be located near the tools, e.g. in a distance of 100 m or less from the tools. They can even be located in close proximity to the process chamber as the point of use, e.g. the distance can be 10 m or less.

The step of delivery preferably denotes passing the fluorine from the manufacturing apparatus to the point of use through pipes, especially through pipes which remain permanently connected to prevent intrusion of air into the fluorine, and to prevent fluorine to leak out.

In a preferred embodiment, the step of low temperature treatment to remove HF, the step of delivery of the treated F₂ to the point of use, any step of storage and the optional, but preferably performed steps of removing entrained solids, and the step of removal of any residual HF by means of an adsorption, preferably by contacting the F₂ with NaF, are performed at a pressure greater than ambient pressure ; preferably, the steps are performed at a pressure equal to or greater than 1.5 bar (abs), and more preferably, at a pressure equal to or greater than 2 bar (abs). Preferably, said steps are performed at a pressure equal to or lower than 20 bar (abs).

In another embodiment of on site production with greater demand of fluorine, especially in the manufacture of TFTs for LCDs, the pressure of the fluorine in said steps to the tool is preferably equal to or greater than 3 Bara.

The method of the present invention allows for the delivery of elemental fluorine to the point of use with a low content of HF, or with no HF at all.

The following example is intended to explain the invention in detail without limiting it.

### Example 1 : Provision of elemental fluorine with low HF content on-site to the point of use for chamber cleaning

### 1. Manufacture of elemental fluorine

An electrolyte salt with a composition of about KF·2HF is filled into an electrolysis cell, heated to about 80 - 120°C and molten therein. HF is introduced into the electrolytic cell. A voltage of between 8 to 10 V is applied, and current is passed through the composition of the molten electrolyte salt and hydrogen fluoride ; the content of the cell is kept in a range of about 80 to 100°C. Elemental fluorine and elemental hydrogen form in the respective electrode compartments. The generated elemental fluorine is passed through a Monel metal frit to remove solids and pressurized by means of a compressor to about 10 Bar abs. and then passed through a trap cooled to -80°C ; in this trap, entrained HF condenses. The gaseous F₂ leaving the trap is passed through a bed of NaF to remove any residual HF.

### 2. Delivery of the purified F₂ to the chamber

The compressed fluorine is then passed, if desired after depressurization to about 2 to 3 Bar abs., in a pipe directly to a semiconductor-manufacturing tool located on-site. In this tool, the elemental fluorine is applied for the cleaning of the inner walls of a plasma chamber to remove silicon-containing residues deposited during the PECVD (plasma-enhanced vapor deposition) layers in a process for the manufacture of semiconductors.

## Claims

1. A method for the manufacture of electronic devices comprising at least a step of the manufacture of the elemental fluorine on site electrolytically and cleaning a chamber using elemental fluorine as chamber cleaning agent wherein, after its manufacture, the elemental fluorine and before its application for chamber cleaning is subjected to a low temperature treatment, wherein the elemental fluorine is cooled to a temperature equal to or lower than -60°C, at a pressure of equal to or greater than 1.5 Bar Absolute to remove at least a part of entrained hydrogen fluoride and subsequently subjected to at least one absorption step.

2. The method of any one of claims 1 to 3 wherein the elemental fluorine is produced by electrolysis of HF in the presence of a molten HF adduct of KF as electrolyte salt.

3. The method of any one of claims 1 to 2 wherein elemental fluorine is produced in a generator, and the generator for elemental fluorine is in fluid communication with the chamber.

4. The method of any one of claims 1 to 3 wherein the chamber to be cleaned is a thermal or plasma-assisted chamber.

5. The method of claim 1 wherein the cleaning is performed thermally or plasma-assisted.

6. The method of any one of claims 1 to 5 wherein the fluorine is manufactured in a cassette.

7. The method of any one of claims 1 to 6 wherein the fluorine is manufactured in a skid.

## Patentansprüche

1. Verfahren zur Herstellung von elektronischen Vorrichtungen, umfassend mindestens einen Schritt der elektrolytischen Herstellung des elementaren Fluors vor Ort und Reinigen einer Kammer unter Verwendung von elementarem Fluor als Kammerreinigungsmittel, wobei nach der Herstellung und vor der Anwendung für die Kammerreinigung das elementare Fluor einer Niedertemperaturbehandlung ausgesetzt wird, wobei das elementare Fluor auf eine Temperatur gleich oder kleiner als -60°C gekühlt wird, bei einem Druck von gleich oder größer als 1,5 bar absolut, um mindestens einen Teil des mitgerissenen Wasserstofffluorids zu entfernen, und daraufhin mindestens einem Absorptionsschritt ausgesetzt wird.

2. Verfahren nach einem der Ansprüche 1 bis 3, wobei das elementare Fluor durch Elektrolyse von HF in Gegenwart eines geschmolzenen HF-Addukts von KF als Elektrolytsalz erzeugt wird.

3. Verfahren nach einem der Ansprüche 1 bis 2, wobei elementares Fluor in einem Generator erzeugt wird und der Generator für elementares Fluor in Fluidverbindung mit der Kammer steht.

4. Verfahren nach einem der Ansprüche 1 bis 3, wobei die zu reinigende Kammer eine wärme- oder plasmaunterstützte Kammer ist.

5. Verfahren nach Anspruch 1, wobei die Reinigung wärme- oder plasmaunterstützt durchgeführt wird.

6. Verfahren nach einem der Ansprüche 1 bis 5, wobei das Fluor in einer Kassette hergestellt wird.

7. Verfahren nach einem der Ansprüche 1 bis 6, wobei das Fluor in einem Rahmen hergestellt wird.

## Revendications

1. Procédé de fabrication de dispositifs électroniques comprenant au moins une étape de fabrication de fluor élémentaire sur site par voie électrolytique et le nettoyage d'une chambre au moyen de fluor élémentaire en tant qu'agent de nettoyage de chambre, dans lequel, après sa fabrication et avant son application pour le nettoyage de la chambre, le fluor élémentaire est soumis à un traitement à basse température, dans lequel le fluor élémentaire est refroidi jusqu'à une température égale ou inférieure à -60 °C à une pression égale ou supérieure à 1,5 bar absolu pour retirer au moins une partie du fluorure d'hydrogène entraîné et ensuite soumis à au moins une étape d'absorption.

2. Procédé de l'une quelconque des revendications 1 à 3 dans lequel le fluor élémentaire est produit par électrolyse de HF en présence d'un adduit de HF fondu et de KF comme sel électrolytique.

3. Procédé de l'une quelconque des revendications 1 à 2 dans lequel le fluor élémentaire est produit dans un générateur, et le générateur pour fluor élémentaire est en communication fluidique avec la chambre.

4. Procédé de l'une quelconque des revendications 1 à 3 dans lequel la chambre à nettoyer est une chambre thermique ou à assistance plasma.

5. Procédé de la revendication 1 dans lequel le nettoyage est effectué thermiquement ou avec assistance plasma.

6. Procédé de l'une quelconque des revendications 1 à 5 dans lequel le fluor est fabriqué dans une cassette.

7. Procédé de l'une quelconque des revendications 1 à 6 dans lequel le fluor est fabriqué dans un châssis mobile.
